# EUROPEAN PATENT APPLICATION

(11) **EP 1 460 685 A1**
(43) Date of publication of application: **22.09.2004**
(21) Application number: 04005583.2
(22) Date of filing: 09.03.2004
(51) Int. Cl.: H01L 21/768, H01L 21/312

(54) **Semiconductor device and method of manufacturing the same**

(30) Priority: 17.03.2003 JP 2003071888
(71) Applicant: Semiconductor Leading Edge Technologies, Inc., Ibaraki 305-8569 (JP)
(72) Inventor: Kaji, Naruhiko, Tsukuba-shi Ibaraki 305-8569 (JP)
(74) Representative: Hofer, Dorothea, Dr.

(57) **Abstract**

A semiconductor device comprises an inorganic film on a semiconductor substrate, an intermediate film on the inorganic film and containing silicon, and an organic film on the intermediate film and containing fluorine. The organic film is made of a fluorinated arylene film. The fluorinated arylene film is made of a poly(tetrafluoro-p-xylylene), or a derivative thereof, having recurring units of formula (1) 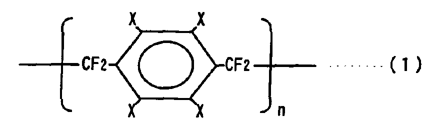 wherein X is hydrogen or fluorine. The inorganic film is made of a material that is selected from the group consisting of SiO₂, SiN, SiC, SiOC, SiCN and SiON.

## Description

### Background of the Invention

### Field of the Invention

The present invention relates to semiconductor devices and methods for manufacturing a semiconductor device, and more particularly, to a semiconductor device having an insulating film with a low dielectric constant and a method for manufacturing such a semiconductor device.

### Background Art

In recent years, an increase of speed of a semiconductor device is so remarkable that a problem on the delay of transmission has been presented owing to the lowering of a signal propagation speed ascribed to the parasitic capacitance between a wiring resistor and wiring or a wiring layer in a multi-layered wiring structure. Such a problem tends to become more pronounced for the reason that as the wiring width and space are made finer as a result of the high degree of integration of a semiconductor device, the wiring resistance rises with an increasing parasitic capacitance.

In order to prevent the signal delay based on such increased wiring resistance and parasitic capacitance, attempts have been hitherto made to use a copper wire in place of aluminum wiring and also to use an insulating film material of low dielectric constant as a layer insulating film. For instance, organic insulating materials are known including a SiOC (silicon oxide carbide, i.e. carbon doped silicon oxide) wherein a methyl group is introduced into SiO₂ (silicon oxide) and a polyaryl ether derivative film. However, these films have a dielectric constant of about 2.6 ~ 2.9. There is now a demand of further lowering a dielectric constant for a semiconductor device of the generation where the scale-down of a design rule is more advanced.

On the other hand, SiO₂ (silicon oxide) is formed as a porous film is known as an insulating film of a dielectric constant that is as low as about 2.0 ~ 2.4. Such a porous film is significantly lowered in mechanical strength, with the attendant problem that the insulating film suffers cracking in the course of the manufacture. Moreover, the gases or chemicals used or generated during the manufacture are absorbed in the pores of the porous film, thus presenting a problem of lowering film characteristics and a problem wherein an after-treatment becomes necessary so as to prevent the lowering of such characteristics.

A fluorinated arylene film has been proposed as another type of insulating film material that satisfies a low dielectric constant of about 2.0 ~ 2.4 without resorting to the porosity of the film. However, since the fluorinated arylene film contains fluorine (F), it has poor adhesion to inorganic films such as a SiO₂ (silicon oxide) film, a SiN (silicon nitride) film, and a SiC (silicon carbide) film, with the problem that a failure occurs in the separation of the films.

### Summary of the Invention

The invention has been accomplished in view of such problems as set out hereinabove. More particularly, an object of the invention is to provide a semiconductor device using an organic insulating film material which is able to realize a low electric constant and a method for manufacturing such a semiconductor device.

Another object of the invention is to provide a semiconductor device wherein any failure such as of film separation does not occur in the course of its manufacture and also a method for manufacturing such a semiconductor device.

Further objects and advantages of the invention will become apparent from the following description.

According to one aspect of the present invention, a semiconductor device comprises an inorganic film on a semiconductor substrate, an intermediate film on the inorganic film and containing silicon, and an organic film on the intermediate film and containing fluorine.

According to another aspect of the present invention, a semiconductor device having a multilayer wiring structure, comprises a first insulating film on a lower wiring layer, an intermediate film on the first insulating film and containing silicon, and a second insulating film on the intermediate. The second insulating film is a interlayer insulating film with a low dielectric constant containing fluorine.

According to another aspect of the present invention, in a method of manufacturing a semiconductor device, an inorganic is formed film on a semiconductor substrate. The inorganic film is subjected to plasma treatment. An organic film containing fluorine is formed on the plasma-treated inorganic film.

According to other aspect of the present invention, in a method of manufacturing a semiconductor device, an inorganic film is formed on a semiconductor substrate. An intermediate film containing silicon is formed on the inorganic film. An organic film containing fluorine is formed on the intermediate film.

Other and further objects, features and advantages of the invention will appear more fully from the following description.

### Brief Description of the Drawings

Fig.1A shows a method of forming a thin film according to the first embodiment.
Fig.1B shows a method of forming a thin film according to the first embodiment.
Fig.1C shows a method of forming a thin film according to the first embodiment.
Fig.2 shows an apparatus for forming a thin film.
Fig.3A shows a method of forming a thin film according to the second or third embodiment.
Fig.3B shows a method of forming a thin film according to the second or third embodiment.
Fig.3C shows a method of forming a thin film according to the second or third embodiment.
Fig.4 shows a relationship between temperature and dielectric constant.
Fig.5 shows a semiconductor device having a multilayer wiring structure.
Fig.6 shows a semiconductor device having a multilayer wiring structure.

### Detailed Description of the Preferred Embodiments

The embodiments of the present invention will be described in more detail with reference to the accompanying drawings.

### First Embodiment

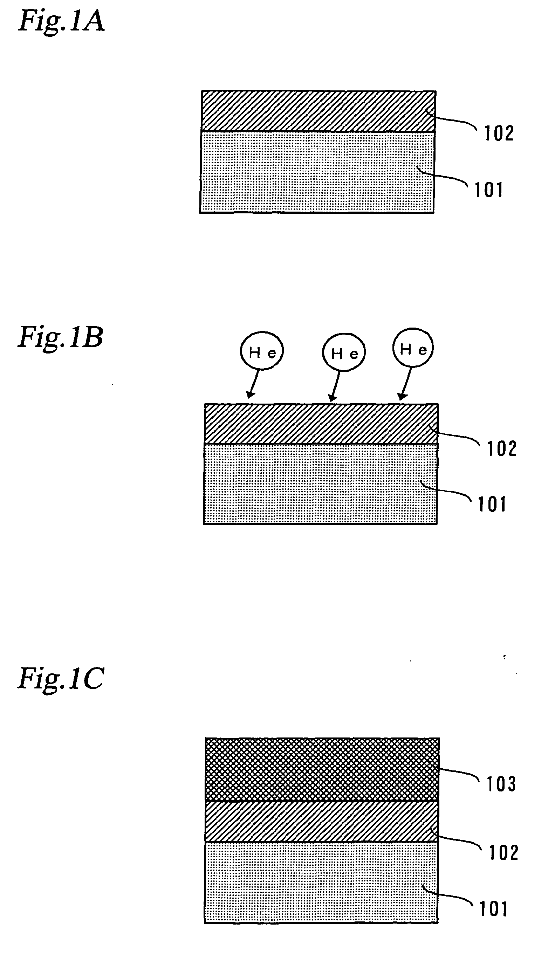

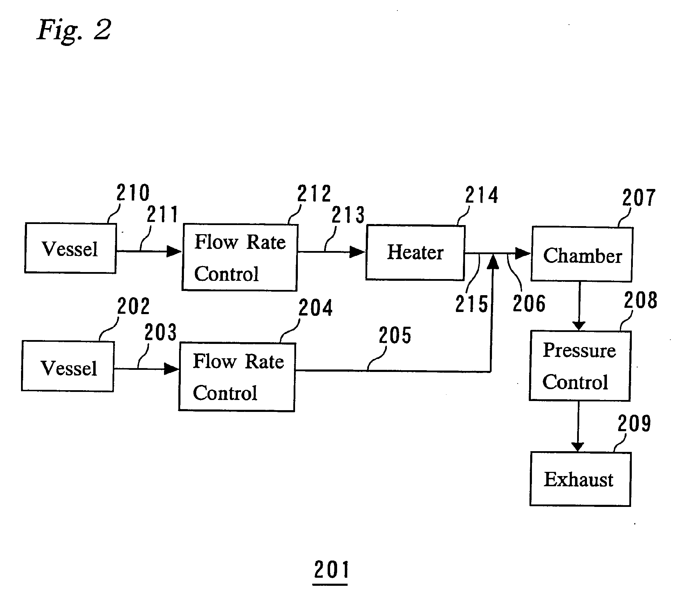

Referring now to Figs. 1A, 1B, 1C and 2, a first embodiment will be illustrated. Figs. 1A to 1C are schematic views showing a method for forming a thin film according to the embodiment. Fig. 2 is a block diagram of a thin film-forming apparatus of this embodiment. This embodiment is characterized in that an organic insulating film of low dielectric constant is formed after the surface treatment of an inorganic film with plasma.

Initially, as shown in Fig. 1A, a substrate is provided wherein an inorganic film 102 with a given thickness has been formed on a semiconductor substrate 101. The inorganic film may be used material having a large etching rate ratio with respect to an organic film. The inorganic film may be used, for example, a SiO₂ film, a SiN film, a SiC film, a SiOC film, a SiCN film, a SiON film and the like and can be formed, for example, by a plasma CVD (chemical vapor deposition) technique.

It will be noted that the semiconductor substrate is, for example, one where a gate electrode is formed on a silicon substrate. The silicon substrate may have an element isolation region and a diffusion layer converted to a source or drain.

Next, the substrate wherein an inorganic film has been formed on the semiconductor substrate is set in a film-forming chamber 207 of the thin film-forming apparatus 201 of Fig. 2.

In the thin film-forming apparatus 201 of Fig. 2, a gas for plasma treatment is placed in an accommodation vessel 202. The gas for plasma treatment used in this embodiment preferably includes rare gases such as He, Ne and Ar, N₂, H₂ and the like, of which He is most preferred.

The gas for plasma treatment is passed to a pipe 203 and its flow rate is controlled at a given level by a flow rate control means 204, followed by passing through a pipe 205 toward a pipe 206. Thereafter, the gas is introduced into the film-forming chamber 207 from the pipe 206. The film-forming chamber 207 is evacuated to a given level of vacuum in the inside thereof. The substrate on which the inorganic film has been formed is placed in the film-forming chamber 207 while keeping at a given temperature.

Next, electrodes (not shown) disposed within the film-forming chamber 207 are applied with a radio frequency (RF) so that the surface of the inorganic film is subjected to plasma treatment.

For instance, as shown in Fig. 1B, a surface of the inorganic film 102 is treated with plasma by use of a He gas. More specifically, a He gas is fed at a flow rate of 100 sccm and a pressure of 1 Torr., against the substrate wherein a SiC film has been formed on a silicon substrate with a size of 8 inches, followed by application of a radio frequency of 13.56 MHz at 200 W. The plasma treatment time may be, for example, at about 60 seconds. The substrate can be kept, for example, at a temperature suited for the film formation of an organic film in a subsequent step.

The gas generated through the plasma treatment and an excess gas for plasma treatment are discharged to outside of the thin film-forming apparatus 201 through a pressure control device 208 by means of an exhaust device 209.

The plasma treatment of the inorganic film on the surface thereof in this way allows the surface layer alone of the inorganic film to be improved within a short time. When an organic film of low dielectric constant is subsequently formed on the inorganic film, it becomes possible to realize good adhesion between the inorganic film and the organic film.

Next, as shown in Fig. 1C, an organic film 103 of low dielectric constant is formed on the inorganic film 102. In this embodiment, it is preferred to rapidly form the organic film subsequently to the plasma treatment. When using the thin film-forming apparatus of Fig. 2, the organic film can be continuously formed within the same film-forming chamber while keeping the vacuum after the plasma treatment.

In the thin film-forming apparatus 201, a starting gas for a low dielectric constant organic film is placed in the accommodation vessel 210. For the organic film, a fluorinated arylene film may be used, for example. In this case, the starting gas used is a compound of the following formula including, for example, di-α, α', α", α' "-(tetrafluoro-p-xylylene) of the formula (4), its derivative of the formula (5), or dibromotetrafluoro-p-xylylene of the formula (6) or its derivative of the formula (7).

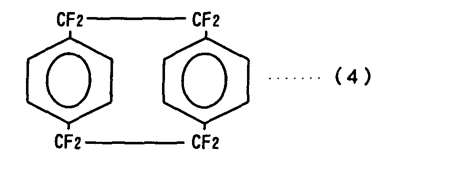

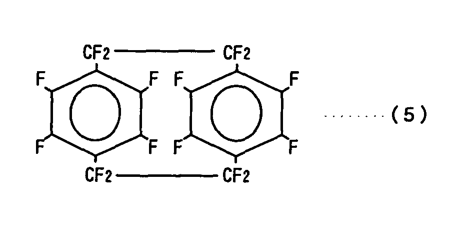

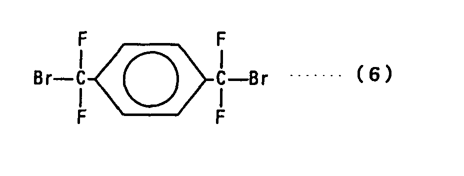

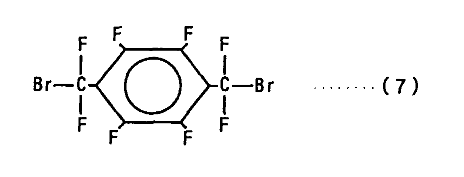

The starting gas within the accommodation vessel 210 is passed from a pipe 211 through a flow rate control means 212 to a pipe 213, followed by feeding to a heating means 214. The flow rate control means 212 controls the flow rate of the starting gas fed to the heating means 214 at a given level. In the heating means 214, the starting gas is thermally decomposed at a temperature of 500° C to 650° C, preferably 550° C to 600° C, thereby forming a gaseous polymer precursor.

For instance, where the di-α, α', α", α'"-(tetrafluoro-p-xylylene) compound of the formula (4), its derivative of the formula (5), or dibromotetrafluoro-p-xylylene of the formula (6) or its derivative of the formula (7) is used as the starting material, there is produced a (tetrafluoro-p-xylylene) polymer precursor gas or a precursor gas of a (tetrafluoro-p-xylylene) polymer derivative.

The polymer precursor gas produced in the heating means 214 is transmitted to the film-forming chamber 207 via the pipes 215 and 206.

The substrate obtained after completion of the plasma treatment is disposed within the film-forming chamber 207. This substrate is kept at a surface temperature of -50° C to 0°C, preferably -40°C to -30° C and the polymer precursor gas is passed over the inorganic film. At this stage, the flow rate of the polymer precursor gas is set, for example, at 5 sccm and the film-forming pressure is set, for example, at 20 mTorr. Thereafter, the polymer precursor gas is condensed and polymerized to form a fluorinated arylene film for use as an organic film of low dielectric constant on the inorganic film. It will be noted that an excess polymer precursor gas is discharged through the pressure control device 208 to the outside of the thin film-forming apparatus 201 by means of an exhaust device 209.

When the di-α, α', α", α" '-(tetrafluoro-p-xylylene) compound of the formula (4) or dibromotetrafluoro-p-xylylene of the formula (6) is used as the starting material for a fluorinated arylene film, a thin film of poly(tetrafluoro-p-xylylene having recurring units represented by the formula 8 is formed. Where the compound represented by the formula 5 or 7 is used as the starting material, a thin film of a poly(tetrafluoro-p-xylylene) derivative having recurring units represented by the formula 9 is formed. It is to be noted that the thickness of the formed fluorinated arylene film can be controlled by controlling the film-forming time in the film-forming chamber. The thickness of the fluorinated arylene film can be set, for example, at about 200 nm to 1.5 µm.

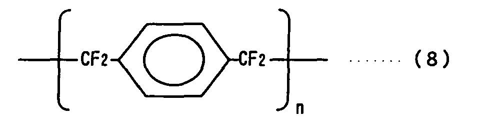

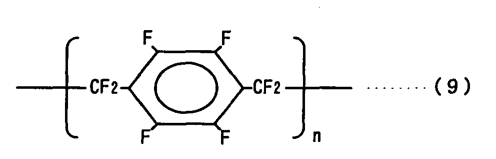

In the practice of the invention, it is preferred to carry out thermal treatment after the formation of the fluorinated arylene film. Although the polymer deposited on the semiconductor substrate has only weak crystallinity prior to the thermal treatment, crystallization proceeds when the thermal treatment is carried out at a temperature of not lower than 350° C and can further proceed when the thermal treatment is effected at 400° C. Accordingly, the thermal treating conditions include a temperature of about 300° C to about 500° C, preferably about 350° C to about 400° C, and a time of 30 minutes to 180 minutes, preferably 60 minutes to 90 minutes. When the temperature is lower than 300° C, satisfactory mechanical strength is not ensured. On the other hand, when the temperature is higher than 500° C, the decomposition reaction of the polymer forming the deposited film takes place.

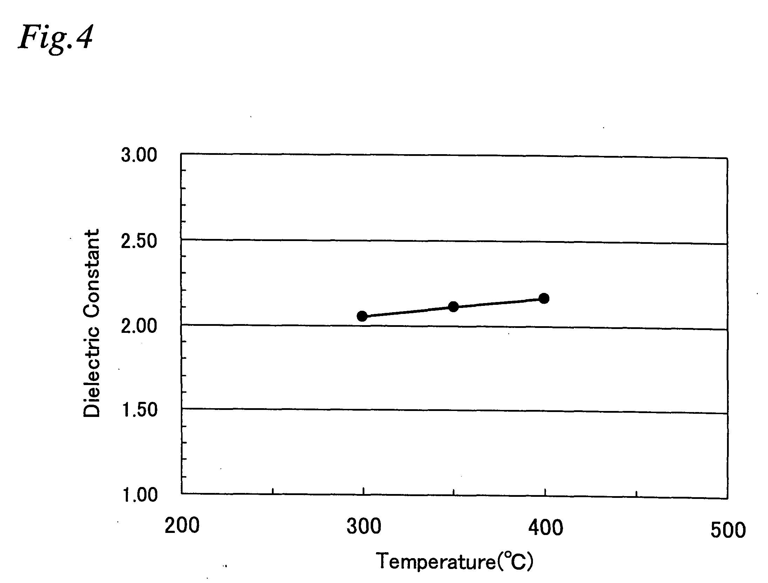

Fig. 4 shows an example of the relationship between thermal treatment temperature and the dielectric constant of a fluorinated arylene film. Table 1 shows an example of the relationship between thermal treatment temperature and the mechanical strength of a fluorinated arylene film. Incidentally, a poly(tetrafluoro-p-xylylene) film of formula 8 is used as the fluorinated arylene film. It is seen from Fig. 4 and Table 1 that, as the heating temperature is raised, the mechanical strength is great increased while the dielectric constant is slightly raised.

**[Table 1]**

| | | | |
|---|---|---|---|
| Thermal treatment temperature (°C) | 300 | 350 | 400 |
| Young's modulus (Gpa) | 6.0 | 7.6 | 9.0 |
| Hardness (Gpa) | 0.31 | 0.35 | 0.37 |

In this embodiment, the fluorinated arylene film is used, and the invention is not limited thereto. Fluorine-containing organic films other than the fluorinated arylene film may also be used. For instance, fluorinated ethylene films, fluorinated polyimide films or fluorinated amorphous carbon films may be used.

According to the embodiment, since an organic film of low dielectric constant is formed after the surface treatment of an inorganic film with plasma, adhesion between the inorganic film and the organic film can be improved. Accordingly, the yield in the semiconductor manufacturing process can be improved with improved reliability of the resulting product.

### Second Embodiment

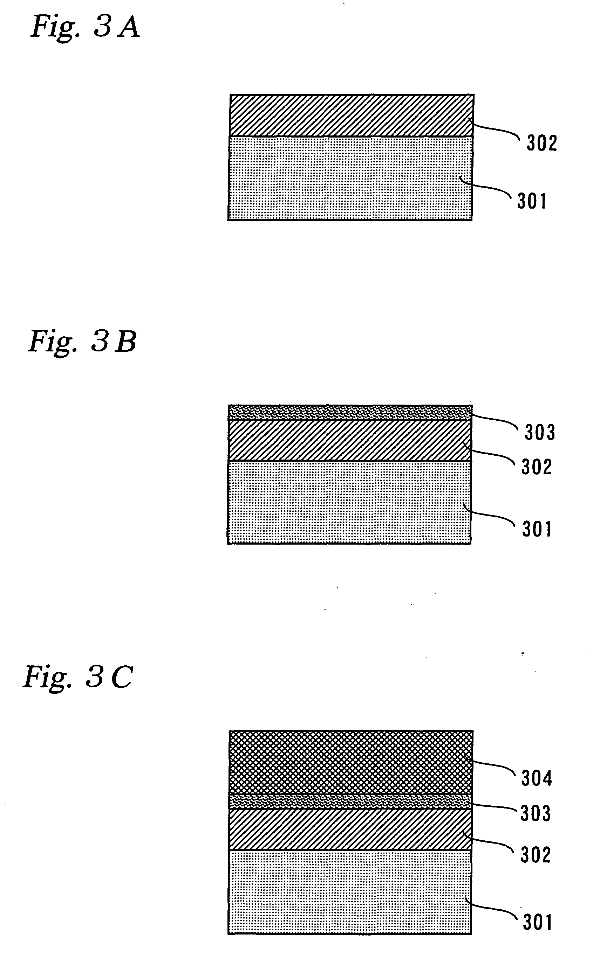

A second embodiment will be described with reference to Figs. 2, 3A, 3B and 3C. Figs. 3A to 3C are schematic views showing a method of forming a thin film in the embodiment. This embodiment is characterized in that an intermediate film is formed between an inorganic film and an organic insulating film of low dielectric constant.

Like the first embodiment, a substrate on which an inorganic film 302 having a given thickness has been formed on a semiconductor substrate 301 is provided (Fig. 3A). For the inorganic film, there can be used, for example, a SiO₂ film, a SiN film, a SiC film, a SiOC film, a SiCN film, a SiON film and the like, and these films can be formed, for example, by a plasma CVD technique.

It will be noted that the semiconductor substrate used may be, for example, one wherein a gate electrode has been formed on a silicon substrate. The silicon substrate may be formed thereon with an element isolation region or a diffusion layer resulting in a source or drain.

Next, as shown in Fig. 3B, a silicon-containing intermediate film 303 is formed on the inorganic film 302. The formation of the intermediate film on the inorganic film leads to improved adhesion with an organic film of low dielectric constant formed in a subsequent step.

The intermediate film can be formed, for example, using a silane coupling agent. More specifically, an intermediate film composition wherein a silane coupling agent is dissolved in an appropriate organic solvent and is applied onto the inorganic film, for example, by spin coating. Thereafter, the organic solvent is removed from the intermediate film composition by thermal treatment. In this way, the film of the silane coupling agent can be formed on the inorganic film. Examples of the organic solvent include alcohols such as ethanol, ketones such as acetone, aromatic compounds such as toluene, and esters such as ethyl acetate. It will be noted that the intermediate composition may further comprise additives such as a leveling agent.

Epoxy silane coupling agents or amino silane coupling agents may be used, for example, as the silane coupling agent. Examples of the epoxy silane coupling agent include 3-glycidoxyropyltrimethoxysilane (formula 10). Examples of the amino silane coupling agent include N-phenyl-3-aminopropyltrimethoxysilane (formula 11) and aminopropyltrimethoxysilane (formula 12). It should be noted that the silicon component used for the intermediate film composition is not limited to a monomer, but may contain an oligomer or polymer of a silane coupling agent.

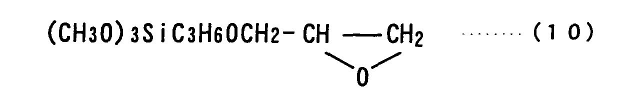

(CH₃O)₃SiC₃H₆NHC₆H₅ (11)

(CH₃O)₃SiC₃H₆NH₂ (12)

(C₂H₅O)₃SiC₃H₆NH₂ (13)

For instance, a solution where aminopropyltriethoxysilane is dissolved in methanol in 10% by volume is applied onto the inorganic film by spin coating. Thereafter, thermal treatment is carried out at 150°C for 5 minutes to remove the organic solvent by evaporation. In this manner, a silicon-containing intermediate film can be formed on the inorganic film.

Alternatively, a silanol compound (formula 14) may be used to form the intermediate film. For instance, an intermediate film composition containing a silanol compound and an appropriate organic solvent is used and applied onto the inorganic film, for example, by spin coating, followed by thermal treatment to remove the organic solvent from the intermediate film composition. This results in the formation of the silicon-containing intermediate film on the inorganic film. Examples of the organic solvent include alcohols such as ethanol, ketones such as acetone, aromatic compounds such as toluene, and esters such as ethyl acetate. The intermediate film composition may further contain additives such as a leveling agent.

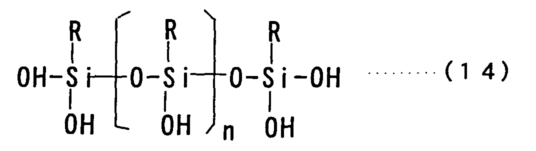

The intermediate film formed consists of a film of an alkylsiloxane polymer, an alkylsilsesquioxane polymer (e.g. methylsilsesquioxane polymer MSQ), a hydrogenated silsesequioxane polymer (HSQ), or a hydrogenated alkylsilsesquioxane polymer (HOSP), which depends on the structure of a siloxane used.

In this embodiment, the intermediate film should preferably be uniformly applied onto the inorganic film. In addition, the intermediate film should preferably have a thickness sufficient to obtain good adhesion force between the inorganic film and the organic film.

Next, as shown in Fig. 3C, an organic film 304 of low dielectric constant is formed on the intermediate film 303. For instance, the substrate is placed in the film-forming chamber 207 of the thin film-forming apparatus 201 of Fig. 2, and a fluorinated arylene film is formed on the intermediate film in the same manner as in the first embodiment. Other type of fluorine-containing organic film other than the fluorinated arylene film may be formed. For example, a fluorinated ethylene film, a fluorinated polyimide film or a fluorinated amorphous carbon film may be formed.

After the formation of the organic film, it is preferred to carry out thermal treatment in the same manner as in the first embodiment. The thermal treatment can facilitate the organic film to be more crystallized, and permits the intermediate film and the inorganic film, and the intermediate film and the organic film to be reacted, respectively, thereby more improving adhesion therebetween for both cases. The heat treating conditions include a temperature of about 300° C to about 500° C, preferably about 350° C to about 400° C, and a time of 30 minutes to 180 minutes, preferably 60 minutes to 90 minutes. If the temperature is lower than 300° C, satisfactory mechanical strength is not ensured. On the other hand, when the temperature is higher than 500° C, the decomposition reaction of the polymer forming the deposited film takes place.

According to the embodiment, since the silicon-containing intermediate film is interposed between the inorganic film and the organic film of low dielectric constant, adhesion between the inorganic film and the organic film can be improved. Accordingly, the yield in the semiconductor manufacturing process can be improved with improved reliability of the resulting product.

For example, after the completion of up to the organic film formation process, incisions reaching the silicon substrate from the organic film were given to a semiconductor device to form 100 small squares each measuring 1 mm × 1 mm in a square measuring 1 cm × 1 cm. Then, a tape was stuck over the incisions and thereafter unstuck from the same with a fixed force. Thus, the adhesion between the films was evaluated by counting the number of the small squares corresponding to part of the organic film that was separated from the counterpart. The results are shown in Table 2. It is to be noted that the adhesion in Table 2 represents (the number of small squares corresponding to part of the organic film separated from the counterpart/100) × 100 (%).

**[Table 2]**

| | Adhesion (%) |
|---|---|
| Prior art | 100 |
| First Embodiment | 4 - 7 |
| Second Embodiment | 0 - 3 |

Table 2 shows that the first and second embodiments are more improved in adhesion than the prior art.

In this embodiment, the procedure of forming a silicon-containing intermediate film by use of a silane coupling agent has been set forth, to which the invention should not be construed as limiting thereto. For instance, the intermediate film may be formed using a compound having a structure wherein an organic functional group is attached to silicon, e.g. a silazane or alkoxysilane.

This embodiment may be used in combination with the first embodiment. In other words, after plasma treatment of the substrate set within the film-forming chamber, a silane coupling agent may be used to form an intermediate film. This permits the adhesion force between the inorganic film and the intermediate film to be improved. The plasma treatment may be carried out by use of a gas such as He, Ne, Ar, N₂ or H₂.

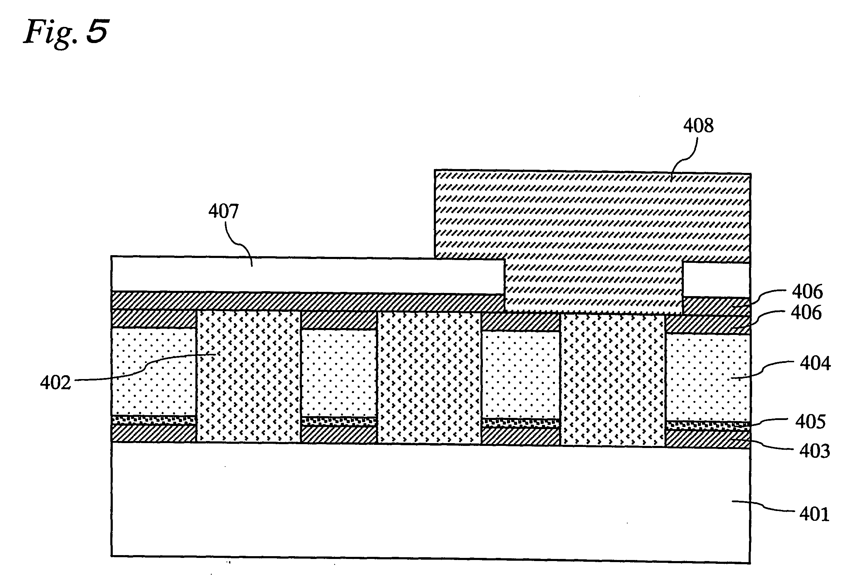

Fig. 5 is a cross-sectional view of a semiconductor device fabricated in accordance with the present embodiment, showing an example in which a copper wiring layer 402 is formed on a lower wiring layer 401. Although the structure of the lower wiring layer 401 is omitted for simplificaton, the lower wiring layer 401 may be configured such that a tungsten plug reaching a diffusion layer is formed in a silicon substrate.

Referring to Fig. 5, a first insulating film 403 serves as the inorganic film of this embodiment and acts as a diffusion-preventive film. A second insulating film 404 serves as the fluorine-containing organic film of this embodiment and acts as an interlayer insulating film of low dielectric constant (a dielectric constant of 2.0 to 2.4). An intermediate film 405 according to the embodiment is interposed between the first insulating film 403 and the second insulating film 404. Incidentally, reference numerals 406, 407, and 408 denote a SiC film, a SiO₂ film and an aluminum wiring layer, respectively.

The first insulating film 403 may have a thickness of, e.g., about 30 to 50 nm. The intermediate film 405 may have a thickness of, e.g., about 5 to 10 nm. The second insulating film 404 may have a thickness of, e.g., about 150 to 200 nm.

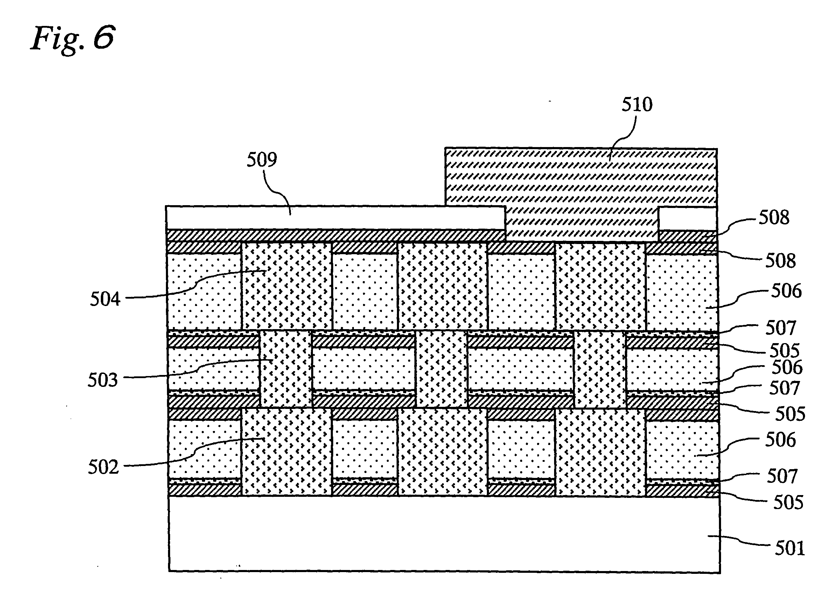

Fig. 6 is a cross-sectional view of another example semiconductor device according to the present embodiment. Referring to Fig. 6, a first copper wiring layer 502 formed on a lower wiring layer 501 is electrically connected to a second copper wiring layer 504 through a via plug 503. A first insulating film 505 serves as the inorganic film of this embodiment and acts as a diffusion-preventive film. A second insulating film 506 serves as the fluorine-containing organic film (second organic film) and acts as an interlayer insulating film of low dielectric constant. An intermediate film 507 according to the embodiment is interposed between the first insulating film 505 and the second insulating film 506. Incidentally, reference numerals 508, 509, and 510 denote a SiC film, a SiO₂ film and an aluminum wiring layer, respectively.

The copper wiring layer in the example of Fig. 5 is formed by a Damascene method. For example, the second insulating film 404 is dry-etched to define an opening reaching the lower wiring layer 401. Thereafter the opening is filled with copper to form the copper wiring layer 402. This copper filling is achieved by forming a copper layer by plating to fill the opening and then polishing its surface to leave copper only in the opening by a CMP (Chemical Mechanical Polishing) method. Incidentally, the same is true of the example of Fig. 6.

According to the embodiment, the existence of the intermediate film 405 improves the adhesion between the second insulating film 404 and the first insulating film 403. Likewise, the existence of the intermediate film 507 improves the adhesion between the second insulating film 506 and the first insulating film 505. Therefore, no separation of the films occurs even if the external force due to the polishing is exerted to the films. Thus, it is possible to manufacture a semiconductor device excellent in electric characteristics and reliability.

Incidentally, although Fig. 6 shows the two wiring layers by way of example, the present embodiment is applicable to the example of a multilayer wiring structure having three layers or more (e.g., ten layers).

### Third Embodiment

A third embodiment will be described with reference to Figs. 2, 3A, 3B and 3C. The semiconductor device in this embodiment has such a structure as the second embodiment and is characterized in that the intermediate film is formed according to a procedure different from that of the second embodiment.

Like the first embodiment, a substrate wherein an inorganic film 302 having a given thickness has been formed on a semiconductor substrate 301 is provided (Fig. 3A). Examples of the inorganic film include a SiO₂ film, a SiN film, a SiC film, a SiOC film, a SiCN film, and a SiON film, and these films can be formed, for example, by a plasma CVD technique.

It will be noted that the semiconductor substrate used may be, for example, one wherein a gate electrode has been formed on a silicon substrate. The silicon substrate may be formed thereon with an element isolation region or a diffusion layer resulting in a source or drain.

Next, as shown in Fig. 3B, a silicon-containing intermediate film 303 is formed on the inorganic film 302. In this embodiment, a vapor of a silane coupling agent is used to form the intermediate film, for example, by use of the thin film-forming apparatus 201 of Fig. 2.

An epoxy silane coupling agent such as, for example, 3-glycidoxypropyltrimethoxysilane may be used as the silane coupling agent. Alternatively, an amino silane coupling agent such as N-Phenyl-3-aminopropyltrimethoxysilane, aminopropyltrimethoxysilane or aminopropyltriethoxysilane may also be used.

In Fig. 2, a silane coupling agent is placed in the accommodation vessel 202. After evaporation and vaporization with a heating device (not shown), the silane coupling agent is fed through a pipe 203 to a flow rate control means 204. After controlling to a given flow rate by the flow rate control means 204, the agent is directed through a pipe 205 toward a pipe 206, followed by introduction from the pipe 206 into a film-forming chamber 207.

The substrate formed with the inorganic film is set in the film-forming chamber 207. When the surface temperature of the substrate is kept low, the vapor of the silane coupling agent introduced into the film-forming chamber 207 is condensed to form a film. In this manner, a silicon-containing intermediate film can be formed on the inorganic film.

For instance, a substrate wherein a SiOC film has been formed on a silicon substrate is set within the film-forming chamber 207. The electrostatic chucks (not shown) for holding the substrate are kept at a temperature of about -30° C. Aminopropyltriethoxysilane is placed in the accommodation vessel 202, and a vapor of aminopropyltriethoxysilane is introduced into the film-forming chamber 207. The thus introduced vapor is condensed on the SiOC film to form a thin film of the aminopropyltriethoxysilane.

Subsequently, as shown in Fig. 3C, an organic film 34 of low dielectric constant is formed on the intermediate film. Using the thin film-forming apparatus 201 of Fig. 2, the formation of the organic film can be continuously performed within the same film-forming chamber 207 while keeping the vacuum after the formation of the intermediate film.

For instance, a polymer precursor gas for fluorinated arylene film is introduced into the film-forming chamber in the same manner as in the first embodiment to form a fluorinated arylene film on the intermediate film. Alternatively, a fluorine-containing organic film other than the fluorinated arylene film may be formed. For example, a fluorinated ethylene film, a fluorinated polyimide film or a fluorinate amorphous carbon film may be formed.

It is preferred that after the formation of the organic film, thermal treatment is carried out in the same manner as in the first embodiment. The thermal treatment not only permits the organic film to be further crystallized, but also causes the intermediate film and the inorganic film and also the intermediate film and the organic film to be reacted with each other, respectively, thereby improving adhesion therebetween. The thermal treating conditions include a temperature of about 300°C to about 500° C, preferably about 350° C to about 400° C, and a time of 30 minutes to 180 minutes, preferably 60 minutes to 90 minutes. If the temperature is lower than 300° C, satisfactory mechanical strength is not ensured. On the other hand, when the temperature is higher than 500° C, the decomposition reaction of the polymer forming the deposited film takes place.

According to this embodiment, the following effects can be obtained, aside from those effects of the second embodiment. More specifically, since an intermediate film and an organic film are continuously formed by use of the thin film-forming apparatus 1, the contamination with foreign matter is prevented, thereby further improving a yield.

It will be noted that in this embodiment, the procedure of forming the silicon-containing intermediate film with use of a silane coupling agent has been set forth, to which the invention should not be construed as limiting thereto. For example, the intermediate film may be formed by using a vapor of a compound having such a structure as to have an organic functional group attached to silicon, e. g., a silazane or alkoxysilane.

This embodiment may be performed in combination with the first embodiment. More specifically, after plasma treatment of a substrate set in the film-forming chamber, an intermediate film is formed by introducing a vapor of a silane coupling agent thereinto. Subsequently, an organic film of low dielectric constant is formed. The plasma treatment is carried out prior to the formation of the intermediate film, so that adhesion between the inorganic film and the intermediate film can be improved. The plasma treatment is effected using a gas of He, Ne, Ar, N₂ or H₂.

The intermediate film formed in the present embodiment is applicable to the examples of Figs. 5 and 6. That is, the respective intermediate films 405 and 507 of Figs. 5 and 6 are each replaceable with the intermediate film of this embodiment.

In the first to third embodiments, instances of forming an organic film of low dielectric constant on an inorganic film have been illustrated, to which the invention is not limited. Other structures may also be used so far as it is intended to improve adhesion between an organic film and an inorganic film, and it is possible to apply these embodiments to all the steps of building up thin films using an organic film.

The features and advantages of the present invention may be summarized as follows.

According to one aspect, an insulating film capable of realizing a low dielectric constant can be provided, so that a parasitic capacitance of a semiconductor device can be significantly reduced, and a signal delay caused by scale-down can be minimized.

According to another aspect, failures such as film separation can be reduced, so that a yield in the course of the manufacture of a semiconductor device can be improved. A semiconductor device of excellent reliability can be manufactured.

Obviously many modifications and variations of the present invention are possible in the light of the above teachings. It is therefore to be understood that within the scope of the appended claims the invention may be practiced otherwise than as specifically described.

The entire disclosure of a Japanese Patent Application No. 2003-071888, filed on March 17, 2003 including specification, claims, drawings and summary, on which the Convention priority of the present application is based, are incorporated herein by reference in its entirety.

## Claims

1. A semiconductor device comprising:
an inorganic film on a semiconductor substrate;
an intermediate film on said inorganic film and containing silicon; and
an organic film on said intermediate film and containing fluorine.

2. The semiconductor device according to claim 1, wherein said organic film is made of a fluorinated arylene film.

3. The semiconductor device according to claim 2, wherein said fluorinated arylene film is made of a poly(tetrafluoro-p-xylylene), or a derivative thereof, having recurring units of formula (1) 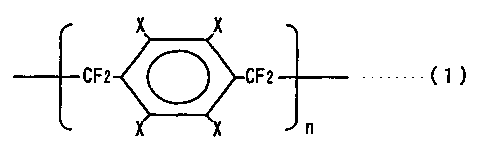 wherein X is hydrogen or fluorine.

4. The semiconductor device according to claim 1, wherein said inorganic film is made of a material that is selected from the group consisting of SiO₂, SiN, SiC, SiOC, SiCN and SiON.

5. A semiconductor device having a multilayer wiring structure, comprising:
a first insulating film on a lower wiring layer;
an intermediate film on said first insulating film and containing silicon; and
a second insulating film on said intermediate;
wherein said second insulating film is an interlayer insulating film with a low dielectric constant containing fluorine.

6. The semiconductor device having a multilayer wiring structure according to claim 5, wherein said second insulating film is made of a fluorinated arylene film.

7. The semiconductor device having a multilayer wiring structure according to claim 6, wherein said fluorinated arylene film is made of a film of a poly(tetrafluoro-p-xylylene), or a derivative thereof, having recurring units of formula (2) 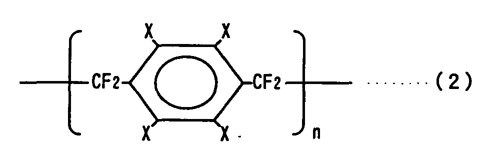 wherein x is hydrogen or fluorine.

8. The semiconductor device having a multilayer wiring structure according to claim 5, wherein said first insulating film is made of a material that is selected from the group consisting of SiO₂, SiN, SiC, SiOC, SiCN and SiON.

9. A method of manufacturing a semiconductor device, said method comprising the steps of:
forming an inorganic film on a semiconductor substrate;
subjecting said inorganic film to plasma treatment; and
forming an organic film containing fluorine on the plasma-treated inorganic film.

10. The method for manufacturing a semiconductor device according to claim 9, wherein said plasma treatment is carried out using a gas selected from the group consisting of He, Ne, Ar, N₂ and H₂.

11. A method of manufacturing a semiconductor device, comprising the steps of:
forming an inorganic film on a semiconductor substrate;
forming an intermediate film containing silicon on said inorganic film; and
forming an organic film containing fluorine on said intermediate film.

12. The method of manufacturing a semiconductor device according to claim 11, wherein the step of forming said intermediate film comprises the steps of:
applying, onto said inorganic film, an intermediate film composition containing a silane coupling agent and an organic solvent; and
removing said organic solvent from said intermediate film composition through thermal treatment.

13. The method of manufacturing a semiconductor device according to claim 12, wherein said silane coupling agent is made of an epoxy-based silane coupling agent or an amino-based silane coupling agent.

14. The method of manufacturing a semiconductor device according to claim 11, wherein the step of forming said intermediate film comprises the steps of:
directing a vapor of a silane coupling agent over said inorganic film; and
condensing said vapor on said inorganic film.

15. The method of manufacturing a semiconductor device according to claim 14, wherein said silane coupling agent is made of an epoxy-based silane coupling agent or an amino-based silane coupling agent.

16. The method for manufacturing a semiconductor device according to claim 11, wherein the step of forming said intermediate film comprises the steps of:
applying, onto said inorganic film, an intermediate film composition containing a silanol compound and an organic solvent; and
removing said organic solvent from said intermediate film composition through thermal treatment.

17. The method for manufacturing a semiconductor device according to claim 11, wherein said intermediate film is formed after plasma treatment of said inorganic film.

18. The method for manufacturing a semiconductor device according to claim 17, wherein said plasma treatment is carried out using a gas selected from the group consisting of He, Ne, Ar, N₂ and H₂.

19. The method for manufacturing a semiconductor device according to claim 9, wherein thermal treatment is carried out at a temperature of 300° C to 500° C after the formation of said organic film.

20. The method for manufacturing a semiconductor device according to claim 11, wherein thermal treatment is carried out at a temperature of 300°C to 500° C after the formation of said organic film.
